# EUROPEAN PATENT SPECIFICATION

(11) **EP 4 595 173 B1**
(45) Date of publication and mention of the grant of the patent: **13.05.2026**
(21) Application number: 23793044.1
(22) Date of filing: 02.10.2023
(51) Int. Cl.: H01S 5/11, G02B 6/122, H01S 5/02, H01S 5/10, H01S 5/34

(54) **SILICON PHOTONIC CRYSTAL**
PHOTONISCHER SILICIUMKRISTALL
CRISTAL PHOTONIQUE DE SILICIUM

(30) Priority: 30.09.2022 IT 202200020172
(43) Date of publication of application: 06.08.2025
(73) Proprietor: Consiglio Nazionale Delle Ricerche, 00185 Roma (IT)
(72) Inventor: CONOCI, Sabrina, 00185 Roma (RM) (IT); IRRERA, Alessia, 00185 Roma (RM) (IT); LEONARDI, Antonio Alessio, 00185 Roma (RM) (IT); SPINELLA, Corrado Rosario, 00185 Roma (RM) (IT)
(74) Representative: Maccalli, Marco
(86) International application number: PCT/IB2023/059849
(87) International publication number: WO 2024/069606

(56) References cited:
- EP-A1- 1 804 350
- US-A1- 2005 157 974
- US-A1- 2014 226 691
- US-A1- 2014 286 367
- US-B2- 8 895 958

## Description

### Technical Field

The present invention relates to a silicon photonic crystal for the enhancement and lasing of the silicon emission. The invention further relates to a method of manufacturing such photonic crystal.

### Background Art

Silicon is an indirect bandgap semiconductor with negligible light emission at room temperature. Many studies have focused on the realization of various nanostructures or the engineering of implants or defects to achieve efficient roomtemperature emission from silicon. However, efficient lasing has not yet been observed. The importance of Auger phenomena for high fluences as well as engineering difficulties in suppressing the presence of non-radiative phenomena are among the main critical issues for silicon in the application as a light source at room temperature. Furthermore, the dimensions required to achieve quantum confinement in silicon have often been prohibitive for many manufacturing techniques and complex to realize for others.

Among the various nanostructures, nanowires stand out due to their robustness and ease of integration with flat fabrication technology such as that required by microelectronics and silicon photonics. In this case, nanowires with diameters below 15 nm are required in order to observe light emission at room temperature by quantum confinement.

EP 1804350 A1 discloses a semiconductor laser that is based on semiconducting elongate nanostructures and that may be fabricated on a silicon-compatible substrate. The structure comprises semiconductive elongate nanostructures that are parallel to one another and that contain a double-heterostructure, which forms the active region of the laser. The semiconducting elongate nanostructures are positioned in a periodic two-dimensional array such that the ensemble of nanowires forms a photonic crystal laser system. At both ends of the elongate nanostructures, there is an electrical contact, which is used to control the lasing action of the system. The fabrication of such a structure on a silicon-compatible substrate is realized by the possibility to grow crystalline elongate nanostructures on a substrate that has a different crystal configuration and lattice constant from the elongate nanostructures.

However, there are no known large-scale manufacturing techniques that would allow the realization of high densities of nanowires with such small dimensions (below 15 nm), having quantum confinement effects and a vertically aligned structure, whereby no photonic crystal capable of amplifying the emission of silicon nanowires and achieving lasing has ever been realized.

At present, silicon photonics is therefore not based on the use of silicon nanowires but on the integration of other active elements as light emitters into the silicon or on the use of external sources coupled to silicon via waveguides or optical fiber. The realization of silicon photonic crystals therefore involves the introduction of other materials whose luminescence can be selected and amplified by the engineering of the crystal and the resonant cavity of the crystal.

Due to the poor light emission of silicon at room temperature, a device for lasing the light emission of silicon is absent.

There is therefore the need for a silicon photonic crystal that is efficient and can increase lasing.

An object of the invention is to provide a silicon photonic crystal that meets the aforesaid need.

Another object of the invention is to provide a silicon photonic crystal that can be easily manufactured.

A further object of the invention is to provide a silicon photonic crystal in which the wavelength of the emitted light can be shifted from the visible to the infrared region.

These and other objects are achieved by the silicon photonic crystal as claimed in the appended claims.

### Summary of Invention

The silicon photonic crystal for the enhancement and lasing of the silicon emission according to the invention comprises periodic silicon structures contiguous with voids, surrounding a silicon resonant cavity consisting of silicon nanowires with uniform doping, which can be either an n-type doping or a p-type doping.

The active medium is therefore represented by the aforementioned resonant cavity nanowires in their entirety and the light emission is due to quantum confinement along the entire length of the nanowires. The active medium of the photonic crystal according to the invention therefore does not comprise heterojunctions.

Optionally, the silicon structures of the photonic crystal also consist of silicon nanowires.

The silicon nanowires have a density of at least 10¹¹ nanowires/cm², more preferably of approximately 10¹² nanowires/cm², a diameter between 4 and 12 nm and a length between tens of nanometers and hundreds of microns.

The silicon nanowires in their entirety constitute the active medium of the photonic crystal, i.e., the material that emits light.

The photonic crystal as described above emits light at about 700 nm at room temperature.

Optionally, the photonic crystal further comprises rare earths and/or luminescent dyes integrated between the silicon nanowires. This allows shifting the light emission to different wavelengths, from the visible to the infrared region.

The method of manufacturing a silicon photonic crystal according to the invention comprises the steps of:
- providing a base silicon photonic crystal, comprising periodic silicon structures contiguous with voids, and a silicon cavity,
- obtaining, in said cavity, a plurality of silicon nanowires entirely made of silicon with uniform doping and without heterojunctions,
wherein the silicon nanowires are made by subjecting said silicon cavity to metal-assisted chemical etching with the use of thin percolative layers of gold as metal catalyst.

Optionally, the method further comprises the step of obtaining a plurality of silicon nanowires also in each of said periodic silicon structures. These silicon nanowires, too, are made by subjecting the periodic silicon structures to metal-assisted chemical etching with the use of thin percolative layers of gold as metal catalyst.

Preferably, the step of obtaining a plurality of silicon nanowires provides, before performing the metal-assisted chemical etching, for:
- applying a resist on the base photonic crystal,
- creating a mask of resist that leaves uncovered only parts (cavity, periodic structures) that are to be subjected to metal-assisted chemical etching,
- depositing percolative layers of gold,
- removing the resist so that percolative layers of gold remain only on parts that are to be subjected to metal-assisted chemical etching.

Preferably, the method further comprises the step of integrating the pluralities of silicon nanowires with rare earths and/or luminescent dyes.

The manufacturing of silicon nanowires on base silicon photonic crystals makes it possible to overcome the biggest limitation of silicon, related to the absence of efficient light emission, and enables the lasing of light emission from silicon nanowires.

Advantageously, the method is feasible by using manufacturing techniques currently used in the microelectronics industry, so that the device is easy to manufacture.

### Brief Description of Drawings

These and other features and advantages of the present invention will become evident from the following description of preferred embodiments given by way of non-limiting examples with reference to the annexed drawings, in which parts identified with identical or similar reference numerals denote parts having identical or similar function and construction, and in which:
- Fig.1: shows a top view of a photonic crystal comprising silicon nanowires according to the invention;
- Fig.2a-2b: show a SEM image of a portion of photonic crystal with silicon nanowires according to the invention and a SEM image of a detail of the silicon nanowires, respectively;
- Fig.3: schematically shows a photonic crystal according to the invention, comprising luminescent dyes integrated in the forest of silicon nanowires;
- Fig.4a-4d: show the steps of a method of manufacturing the photonic crystal according to an embodiment of the invention;
- Fig.5a-5d: show the steps of a method of manufacturing the photonic crystal according to a further embodiment of the invention;
- Fig.6a-6d: schematically show the steps of the process of manufacturing a forest of silicon nanowires;
- Fig.7: shows a graph of the room temperature photoluminescence of a silicon photonic crystal according to the invention, in which two different luminescent dyes are integrated.

### Description of Embodiments

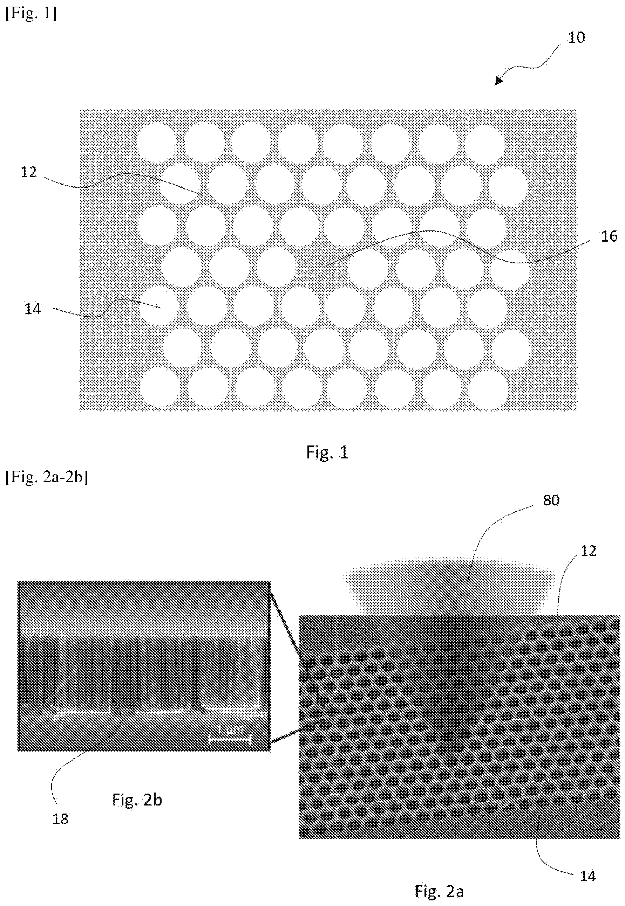

A silicon photonic crystal 10 for the enhancement and lasing of the silicon emission according to an embodiment of the invention is described here below with reference to Figures 1, 2a and 2b.

The photonic crystal 10 comprises a silicon structure 12 periodically interspersed with voids 14 arranged symmetrically, typically to form hexagonal lattices. The photonic crystal 10 further comprises a resonant cavity 16, which interrupts the symmetry and periodicity of the voids 14.

Preferably, the voids 14 have a size between 100 and 500 nm and have distances between them between 50 and 200 nm.

The silicon structure 12, inclusive of the cavity 16, consists of a dense forest of nanowires (NWs) 18 entirely made of silicon with uniform doping, with a density preferably higher than 10¹¹ nanowires/cm², for example of approximately 10¹² nanowires/cm².

The silicon nanowires 18 have a substantially constant diameter, preferably from 4 to 12 nm, for example 7 nm. The lengths of the nanowires 18 may range from tens of nanometers to hundreds of microns.

Said photonic crystal 10 is a photonic crystal whose main medium is silicon.

According to another embodiment, not shown, the photonic crystal may have air as its main medium. In this case, the silicon structure consists of silicon pillars surrounded by voids. The pillars are arranged periodically and symmetrically, typically to form hexagonal lattices, in a manner substantially complementary to the structure of the photonic crystal whose main medium is silicon. Similarly, also in this case the photonic crystal comprises a cavity which interrupts the symmetry and periodicity of the pillars.

The silicon pillars are arranged at mutual distances preferably between 50 and 200 nm, with voids preferably having a size between 50 and 500 nm.

The silicon pillars and the cavity consist of a dense forest of nanowires which are entirely made of silicon with uniform doping, with densities, diameters and lengths equal to those described for the previous embodiment.

The nanowires 18 of the photonic crystal according to the embodiments illustrated above are quantically confined and therefore have a light emission 80 at room temperature that is visible to the naked eye and is centered at 700 nm. The measured full width at half maximum (FWHM) is approximately 150 nm.

In a photonic crystal 10 according to the invention, the nanowires 18 over their entire length are therefore the active medium, i.e., the material that emits light.

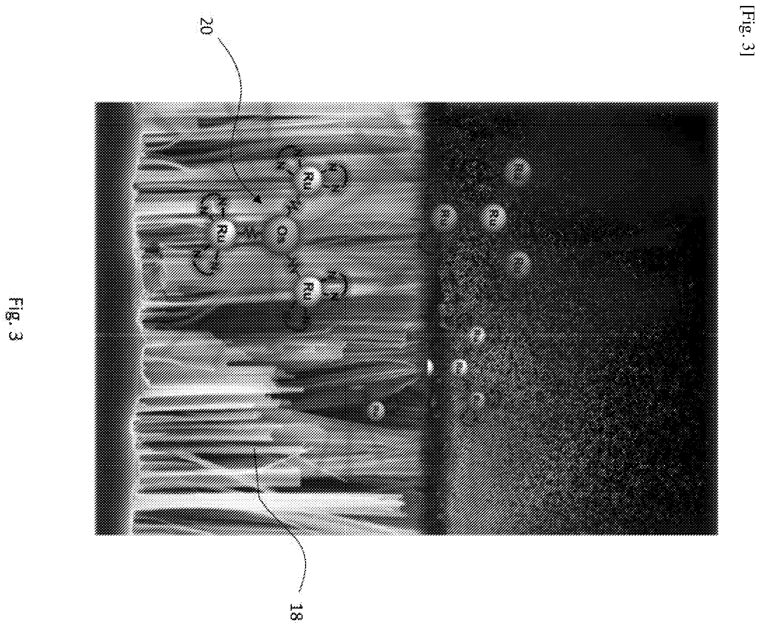

Referring to Figure 3, the silicon photonic crystal 10 according to the invention optionally comprises rare earths (for example, erbium, europium, neodymium, tullium) and/or luminescent dyes 20 (e.g., based on osmium and ruthenium), integrated in the forest of silicon nanowires 18, said rare earths and/or luminescent dyes allowing shifting the light emissions to different wavelengths, from the visible to the infrared region.

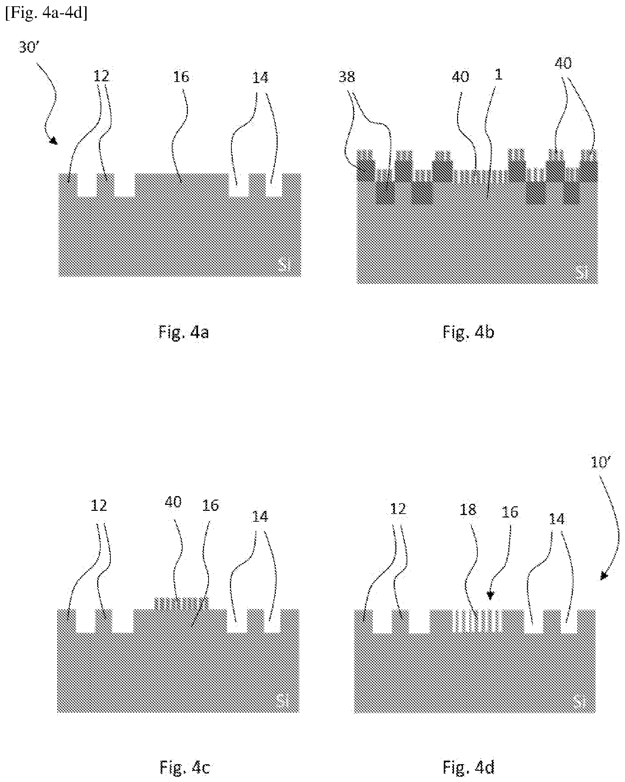

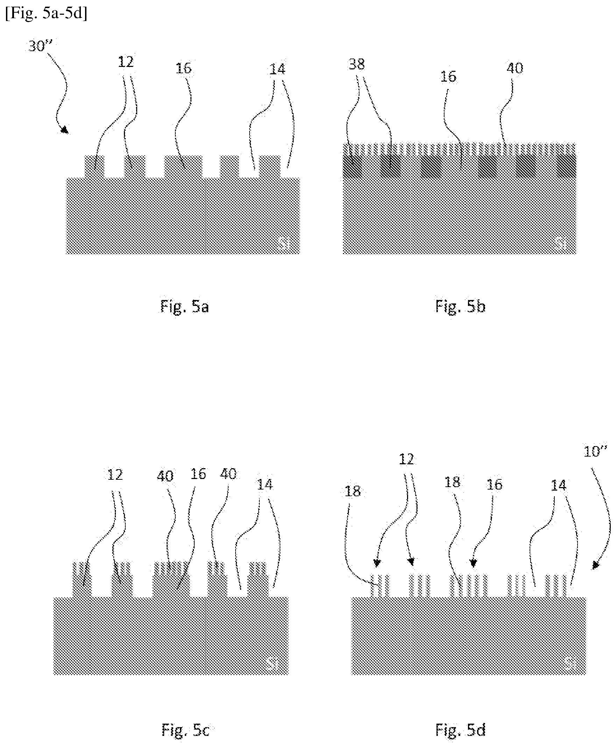

Two embodiments of a method of manufacturing a photonic crystal 10 according to the invention are described below with reference to Figures 4a-d and 5a-d.

At a first step of the method, a base silicon crystal 30', 30", made of silicon, is provided, as shown in Figures 4a and 5a (sectional views).

The base photonic crystal 30' o 30" is manufactured, for example, on a crystalline silicon substrate or on a silicon slice on sapphire (Silicon on Sapphire, SoS) or on a silicon slice on insulator (Silicon on Insulator, SoI), widely used in the field of silicon photonics.

The base photonic crystal 30' o 30" comprises, in a known manner, a periodic silicon structure 12 contiguous with voids 14, and a cavity 16 which interrupts the symmetry of the periodic structure 12.

Subsequently, a forest of silicon nanowires 18 is made either in the cavity 16 of the base photonic crystal 30' (Figures 4b-d) only or in the cavity 16 and in the other silicon structure 12 of the base photonic crystal 30" (Figures 5b-d).

The silicon nanowires 18 are manufactured by the Metal-Assisted Chemical Etching (MECA) technique, catalyzed by thin percolative layers of gold 40.

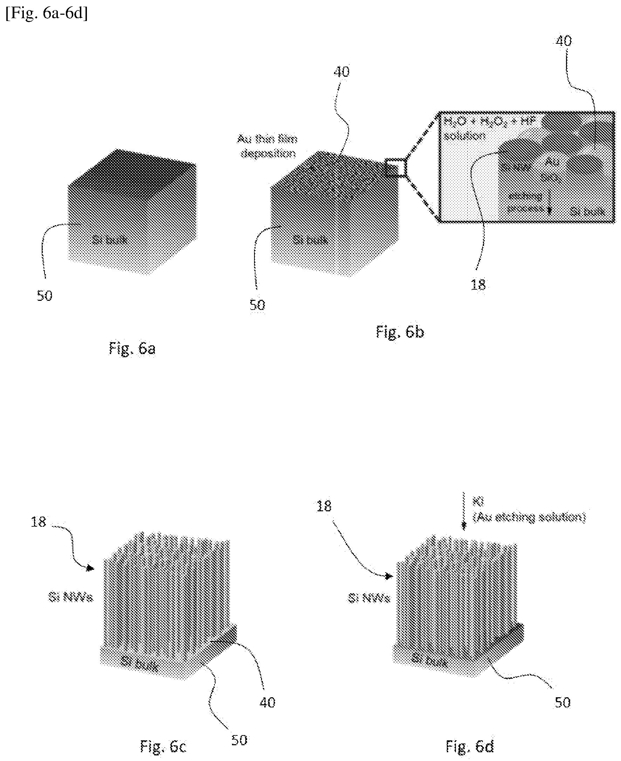

The aforesaid known technique is briefly described with reference to Figures 6a-d. This technique provides for depositing, on a silicon bulk substrate (Si bulk) 50 a non-continuous thin layer (nominal thickness from 2 to 10 nm) of gold (Au) 40 and then immersing the substrate in an aqueous solution of hydrogen peroxide and hydrofluoric acid (Figures 6a e 6b). The chemical reaction at the interface between silicon and gold results in the etching of silicon and the consequent formation of silicon nanowires 18 in the unetched portions (Figure 6c). At the end of the etching, gold 40 is removed, thereby obtaining a silicon substrate with the forest of silicon nanowires 18 (Figure 6d).

The above technique produces a dense forest of silicon nanowires 18 with fractal-like geometry, aligned vertically on the substrate. In particular, the obtained silicon nanowires 18 have diameters from 4 to 12 nm and lengths ranging from tens of nanometers to hundreds of microns. The forest of nanowires 18 has a density higher than 10¹¹ nanowires/cm², for example a density of 10¹² nanowires/cm². Moreover, thanks to the manufacturing technique used, the nanowires 18 can be manufactured with the desired doping.

Referring again to Figures 4b-d, according to a first embodiment of the present method, as anticipated above, the method provides for obtaining a forest of silicon nanowires 18 only in the cavity 16 of the base photonic crystal 30'.

As shown in Figure 4b, at first a layer of resist 38 (sacrificial layer) is applied (for example by spin coating) on the base photonic crystal 30' and then a mask of resist that covers both the voids 14 between the structures 12 of the base silicon photonic crystal 30' and the structures 12 themselves, except for the cavity 16 of the photonic crystal 30', is created (for example by means of optical lithography); a discontinuous layer of gold 40 is then deposited (for example by electron beam evaporation or by sputtering) on the mask of resist 38 and the cavity 16.

At a subsequent step, shown in Figure 4c, lift off of the resist 38 is carried out, after which only the gold layer 40 portion deposited on the cavity 16 of the base photonic crystal 30' is left, whereas the portions deposited on the resist 38 are lifted off together with the resist itself.

At a final step, the silicon nanowires 18 are made at the cavity 16, covered with the gold layer 40, by means of the metal-assisted chemical etching illustrated above. The result, shown in Figure 4d, is a photonic crystal 10' in which the cavity 16 consists of silicon nanowires 18 (the so-called air/silicon photonic crystal with nanowires in its cavity).

Referring again to Figures 5b-d, according to a second embodiment of the present method, as anticipated above, the method provides for obtaining a forest of silicon nanowires 18 not only in the cavity 16 of the base photonic crystal 30", but also in the other silicon structures 12 thereof.

As shown in Figure 5b, at first a layer of resist 38 (sacrificial layer) is applied (for example by spin coating) on the base photonic crystal 30" and then a mask of resist that covers only the voids 14 of the base silicon photonic crystal 30" is created (for example by means of optical lithography); a discontinuous layer of gold 40 is then deposited (for example by means of an electron beam evaporator) on the mask of resist 38 and the structures 12, including the cavity 16, of the base silicon photonic crystal 30" which have been left uncovered by the resist 38.

At a subsequent step, shown in Figure 5c, lift off of the resist 38 is carried out, after which only the portions of gold layer 40 deposited on the structures 12 of the base photonic crystal 30" are left, whereas the portions deposited on the resist 38 are lifted off together with the resist itself.

At a final step, the silicon nanowires 18 are made at all the structures 12 of the base photonic crystal 30", covered with the gold layer 40, by means of the metal-assisted chemical etching technique illustrated above. The result, shown in Figure 5d, is a photonic crystal 10" in which the silicon structures 12 and the cavity 16 consist of silicon nanowires 18 (the so-called air/nanowires photonic crystal).

As already mentioned, the silicon nanowires 18 obtained in the photonic crystal 10, 10', 10" according to one of the embodiments illustrated above are quantically confined and therefore have a light emission at room temperature that is visible to the naked eye and is centered at 700 nm.

Optionally, the method of manufacturing the photonic crystal according to the invention further provides for integrating the forests of silicon nanowires 18 with rare earths (for example, erbium, europium, neodymium, tullium) and/or luminescent dyes 20 (e.g., based on osmium and ruthenium). As mentioned, this allows shifting the light emission to different wavelengths, from the visible to the infrared region.

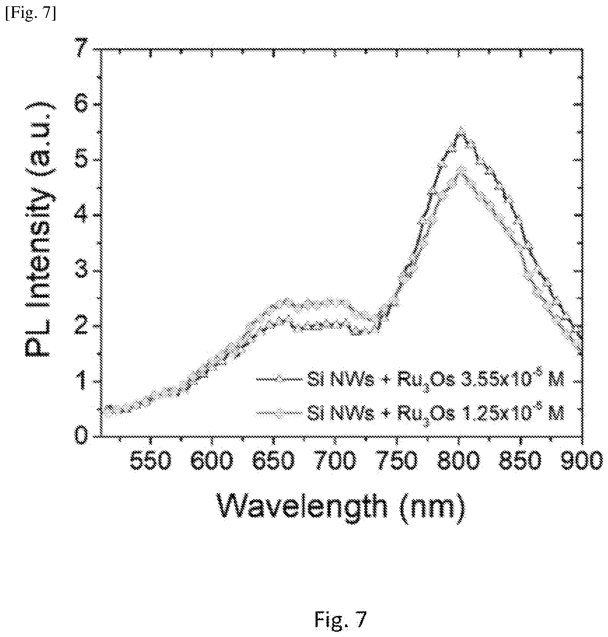

In particular, in the case of dye addition, efficient emission is already achieved at very low dye concentrations, of the order of femtomolar, as shown in Figure 7.

## Claims

1. Silicon photonic crystal (10; 10'; 10") comprising periodic silicon structures (12) contiguous with voids (14), surrounding a silicon resonant cavity (16),
**characterized in that** the resonant cavity (16) consists of nanowires (18) entirely made of silicon with uniform doping, said nanowires acting as active medium of the photonic crystal.

2. Photonic crystal according to claim 1, wherein the silicon structures (12) consist of silicon nanowires (18).

3. Photonic crystal according to claim 2 or 3, wherein the silicon nanowires (18) have a density of at least 10¹¹ nanowires/cm².

4. Photonic crystal according to any one of the preceding claims, wherein the silicon nanowires (18) have a diameter between 4 and 12 nanometers.

5. Photonic crystal according to any one of the preceding claims, wherein the silicon nanowires (18) have a length between tens of nanometers and hundreds of microns.

6. Photonic crystal according to any one of the preceding claims, further comprising rare earths and/or luminescent dyes (20) integrated between the silicon nanowires (18).

7. Method of manufacturing a silicon photonic crystal (10; 10'; 10") according to any one of the preceding claims, the method comprising the steps of:
- providing a base silicon photonic crystal (30'; 30"), comprising periodic silicon structures (12) contiguous with voids (14) and a silicon cavity (16),
- obtaining, in said cavity (16), a plurality of silicon nanowires (18) entirely made of silicon with uniform doping,
wherein the silicon nanowires (18) are made by subjecting said silicon cavity (16) to metal-assisted chemical etching with the use of thin percolative layers of gold (40) as metal catalyst.

8. Method according to claim 7, further comprising the step of:
- obtaining a plurality of silicon nanowires (18) in each of said periodic silicon structures (12), wherein the silicon nanowires (18) are made by subjecting said periodic silicon structures (12) to metal-assisted chemical etching with the use of thin percolative layers of gold (40) as metal catalyst.

9. Method according to claim 7 or 8, wherein said step of obtaining a plurality of silicon nanowires (18) provides, before performing the metal-assisted chemical etching, for:
- applying a resist (38) on the base photonic crystal (30'; 30"),
- creating a mask of resist (38) that leaves uncovered only parts (16; 12, 16) that are to be subjected to metal-assisted chemical etching,
- depositing percolative layers of gold (40),
- removing the resist (38) so that percolative layers of gold (40) remain only on parts (16; 12, 16) that are to be subjected to metal-assisted chemical etching.

10. Method according to any one of claims 7 to 9, further comprising the step of integrating the pluralities of silicon nanowires (18) with rare earths and/or luminescent dyes (20).

## Patentansprüche

1. Photonischer Siliciumkristall (10; 10'; 10"), umfassend periodische Siliciumstrukturen (12), die an Hohlräume (14) angrenzen und einen Siliciumresonanzhohlraum (16) umgeben, **dadurch gekennzeichnet, dass** der Resonanzhohlraum (16) aus Nanodrähten (18) besteht, die vollständig aus Silicium mit einheitlicher Dotierung gefertigt sind, wobei die Nanodrähte als aktives Medium des photonischen Kristalls wirken.

2. Photonischer Kristall nach Anspruch 1, wobei die Siliciumstrukturen (12) aus Siliciumnanodrähten (18) bestehen.

3. Photonischer Kristall nach Anspruch 2 oder 3, wobei die Siliciumnanodrähte (18) eine Dichte von mindestens 10¹¹ Nanodrähten/cm² aufweisen.

4. Photonischer Kristall nach einem der vorhergehenden Ansprüche, wobei die Siliciumnanodrähte (18) einen Durchmesser zwischen 4 und 12 Nanometer aufweisen.

5. Photonischer Kristall nach einem der vorhergehenden Ansprüche, wobei die Siliciumnanodrähte (18) eine Länge zwischen Dutzenden von Nanometern und Hunderten von Mikrometern aufweisen.

6. Photonischer Kristall nach einem der vorhergehenden Ansprüche, ferner umfassend Seltene Erden und/oder zwischen den Siliciumnanodrähten (18) integrierte lumineszierende Farbstoffe (20).

7. Verfahren zur Herstellung eines photonischen Siliciumkristalls (10; 10'; 10") nach einem der vorhergehenden Ansprüche, wobei das Verfahren die folgenden Schritte umfasst:
- Bereitstellen eines photonischen Basis-Siliciumkristalls (30'; 30"), der an Hohlräume (14) angrenzende periodische Siliciumstrukturen (12) und einen Siliciumhohlraum (16) umfasst,
- Erhalten einer Vielzahl von Siliciumnanodrähten (18) in dem Hohlraum (16), die vollständig aus Silicium mit einheitlicher Dotierung gefertigt sind,
wobei die Siliciumnanodrähte (18) gefertigt werden, indem der Siliciumhohlraum (16) einem metallunterstützten chemischen Ätzen unter Verwendung dünner perkolativer Goldschichten (40) als Metallkatalysator unterzogen wird.

8. Verfahren nach Anspruch 7, ferner umfassend den folgenden Schritt:
- Erhalten einer Vielzahl von Siliciumnanodrähten (18) in jeder der periodischen Siliciumstrukturen (12), wobei die Siliciumnanodrähte (18) gefertigt werden, indem die periodischen Siliciumstrukturen (12) einem metallunterstützten chemischen Ätzen unter Verwendung dünner perkolativer Goldschichten (40) als Metallkatalysator unterzogen werden.

9. Verfahren nach Anspruch 7 oder 8, wobei der Schritt des Erhaltens einer Vielzahl von Siliciumnanodrähten (18) vor dem Durchführen des metallunterstützten chemischen Ätzens Folgendes vorsieht:
- Aufbringen eines Resists (38) auf den photonischen Grundkristall (30'; 30"),
- Erstellen einer Maske aus Resist (38), die nur Teile (16; 12, 16) unbedeckt lässt, die einem metallunterstützten chemischen Ätzen unterzogen werden sollen,
- Abscheiden von perkolativen Goldschichten (40),
- Entfernen des Resists (38), sodass perkolative Goldschichten (40) nur auf Teilen (16; 12, 16) verbleiben, die einem metallunterstützten chemischen Ätzen unterzogen werden sollen.

10. Verfahren nach einem der Ansprüche 7 bis 9, ferner umfassend den Schritt des Integrierens der Vielzahl von Siliciumnanodrähten (18) mit Seltenen Erden und/oder lumineszierenden Farbstoffen (20).

## Revendications

1. Cristal photonique de silicium (10 ; 10' ; 10") comprenant des structures périodiques de silicium (12) contiguës à des vides (14), entourant une cavité résonante de silicium (16), **caractérisé en ce que** la cavité résonante (16) est constituée de nanofils (18) entièrement en silicium avec un dopage uniforme, lesdits nanofils agissant en tant que milieu actif du cristal photonique.

2. Cristal photonique selon la revendication 1, dans lequel les structures de silicium (12) sont constituées de nanofils de silicium (18).

3. Cristal photonique selon l'une des revendications 2 ou 3, dans lequel les nanofils de silicium (18) présentent une densité d'au moins 10¹¹ nanofils/cm².

4. Cristal photonique selon l'une quelconque des revendications précédentes, dans lequel les nanofils de silicium (18) présentent un diamètre compris entre 4 et 12 nanomètres.

5. Cristal photonique selon l'une quelconque des revendications précédentes, dans lequel les nanofils de silicium (18) présentent une longueur comprise entre des dizaines de nanomètres et des centaines de microns.

6. Cristal photonique selon l'une quelconque des revendications précédentes, comprenant en outre des terres rares et/ou des colorants luminescents (20) intégrés entre les nanofils de silicium (18).

7. Procédé de fabrication d'un cristal photonique de silicium (10 ; 10' ; 10") selon l'une quelconque des revendications précédentes, le procédé comprenant les étapes de :
- fourniture d'un cristal photonique de silicium de base (30' ; 30"), comprenant des structures périodiques de silicium (12) contiguës à des vides (14) et une cavité de silicium (16),
- obtention, dans ladite cavité (16), d'une pluralité de nanofils de silicium (18) entièrement en silicium avec un dopage uniforme,
dans lequel les nanofils de silicium (18) sont réalisés en soumettant ladite cavité de silicium (16) à une gravure chimique assistée par métal à l'aide de fines couches de percolation d'or (40) en tant que catalyseur métallique.

8. Procédé selon la revendication 7, comprenant en outre l'étape de :
- obtention d'une pluralité de nanofils de silicium (18) dans chacune desdites structures périodiques de silicium (12), lesdits nanofils de silicium (18) étant réalisés en soumettant lesdites structures périodiques de silicium (12) à une gravure chimique assistée par métal à l'aide de fines couches de percolation d'or (40) en tant que catalyseur métallique.

9. Procédé selon l'une des revendications 7 ou 8, dans lequel ladite étape d'obtention d'une pluralité de nanofils de silicium (18) prévoit, avant la réalisation de la gravure chimique assistée par métal, de :
- appliquer une réserve (38) sur le cristal photonique de base (30' ; 30"),
- créer un masque de réserve (38) qui ne laisse découvertes que les parties (16 ; 12, 16) qui doivent être soumises à une gravure chimique assistée par métal,
- déposer des couches de percolation d'or (40),
- retirer la réserve (38) de sorte que les couches de percolation d'or (40) restent uniquement sur les parties (16 ; 12, 16) qui doivent être soumises à une gravure chimique assistée par métal.

10. Procédé selon l'une quelconque des revendications 7 à 9, comprenant en outre l'étape d'intégration des pluralités de nanofils de silicium (18) avec des terres rares et/ou des colorants luminescents (20).
